(19) Europäisches Patentamt

European Patent Office

Office européen des brevets

(11) EP 1 530 051 A1

(12) EUROPEAN PATENT APPLICATION

(43) Date of publication:
11.05.2005 Bulletin 2005/19

(51) Int Cl.7: G01R 1/073

(21) Application number: 04252736.6

(22) Date of filing: 12.05.2004

(84) Designated Contracting States:
AT BE BG CH CY CZ DE DK EE ES FI FR GB GR
HU IE IT LI LU MC NL PL PT RO SE SI SK TR
Designated Extension States:
AL HR LT LV MK

(30) Priority: 07.11.2003 JP 2003378518

(71) Applicant: Nihon Denshizairyo Kabushiki Kaisha
Amagasaki-shi, Hyogo 660-0805 (JP)

(72) Inventors:
• Machida, Kazumichi, Nihon Denshizairyo K.
Kaisha
Amagasaki-shi Hyogo 660-0805 (JP)

• Urata, Atsuo, Nihon Denshizairyo K. Kaisha
Amagasaki-shi Hyogo 660-0805 (JP)
• Mine, Atsushi, Nihon Denshizairyo K. Kaisha
Amagasaki-shi Hyogo 660-0805 (JP)
• Kimura, Teppei, Nihon Denshizairyo K. Kaisha
Amagasaki-shi Hyogo 660-0805 (JP)
• Sakata, Teruhisa, Nihon Denshizairyo K. Kaisha
Amagasaki-shi Hyogo 660-0805 (JP)

(74) Representative: Beresford, Keith Denis Lewis
BERESFORD & Co.
16 High Holborn
London WC1V 6BX (GB)

(54) Probe sheet

(57) A probe sheet unit A is a sensing section of a measuring instrument (not shown) for a measurement objective B and includes: a base plate 100 mounted to a prober of the instrument; and a probe sheet 200 mounted to a lower surface of the base plate, and the probe sheet 200 includes: a sheet member 210 having a flexibility; and plural probes 220 for measurement provided on one surface of the sheet member 210, wherein a probe 220 has a shape capable of elastic deformation in a direction, upward or downward.

FIG. 1

EP 1 530 051 A1

## Description

The present invention relates to a probe sheet used in measurement of electric characteristics of a measurement objective and a probe sheet unit using the same.

There has been available a probe card having a sheet member made of a Teflon(a registered trade mark)-based insulating film and projected probes provided on a surface of the sheet member as disclosed in JP-A No. 8-122364.

A measurement objective in the recent years has been advanced in complexity in an integrated circuit thereof and electrodes thereof have been increasingly miniaturized. With such a high complexity in integrated circuit of a measurement objective, a dispersion in height of electrodes, though extremely low, is revealed. The dispersion in height of electrodes of a measurement objective is further deteriorated due to global inclination and bending of the measurement objective. Therefore, in a case where an electric characteristic of a measurement objective is measured using the probe sheet unit, part of the probes are brought into no contact with corresponding electrodes, leading to an essential problem of disabling correct measurement.

The advancement in complexity in an integrated circuit of a measurement objective entails miniaturization of probes and a smaller pitch between the electrodes, thereby revealing a dispersion in height of probes, though extremely low. The dispersion is further deteriorated by inclination and bending of a probe sheet occurring when the probe sheet is mounted to a prober. In this case as well, part of the probes is not brought into contact with corresponding electrodes, leading to a problem of disabling correct measurement.

In a case where measurement is conducted at temperatures in a wide range (for example, in the range of from 150°C to - 40°C), a measurement objective and a sheet member expand or shrink by a change in temperature independently to each other and thereby, inclination and bending similar to the above described occur, which causes a dispersion in height of electrodes and a dispersion in height of probes to be deteriorated and in addition, also results in a positional shift between an electrode, which is a measurement objective, and a probe. Hence, a problem similar to that described above occurs.

The present invention has been made in light of the above circumstances and it is an object of the present invention to provide a probe sheet capable of achieving correct measurement independently of a dispersion in height of electrodes of a measurement objective; and a probe sheet unit using the same.

According to the present invention, a probe sheet includes a sheet member having a flexibility and plural probes for measurement provided on one surface of the sheet member, wherein a probe has a shape capable of elastic deformation in a direction, upward or downward.

Wiring patterns are formed inside and/or on a surface of the sheet member and an external electrode connected electrically to the probes through the wiring patterns is provided on a surface of the sheet member.

Circuit elements are provided inside and/or on a surface of the sheet member and the circuit elements are connected electrically to the wiring patterns.

In a case where a probe is curved and supported at one end thereof, a reinforcing member with an elasticity higher than the probe may be provided integrally with the probe on a surface thereof opposite the sheet member along the length direction. In a case where the probe is curved and there is a predetermined clearance between a surface of the probe on the other side of the probe from the top of the probe at which the probe is brought into contact with an electrode of a measurement objective and the sheet member, a reinforcing member with an elasticity higher than the probe is inserted in the clearance.

The sheet member is desirably made of a material of a linear expansion coefficient in the range of 2.5 to 10.5 ppm/°C.

A probe sheet unit of the present invention may be a sensing section of a semiconductor wafer measuring instrument and includes: a base plate mounted to a prober of the instrument; the probe sheet mounted to a lower surface of the base plate; and an elastic member interposed between the base plate and the probe sheet.

In a case where a probe sheet related to Claim 1 of the present invention is adopted, probes and a sheet member are elastically deformed independently or together with each other, thereby enabling adaptation for a dispersion in height of electrode of a measurement objective and/or a dispersion in height of the probes. Therefore, since there is no chance that part of the probes is not brought into contact with the corresponding electrodes, which has occurred in a conventional example, thereby enabling correct measurement.

In a case where a probe sheet related to Claim 2 of the present invention is adopted, wiring patterns are formed inside and/or on a surface of a sheet member and provided on a surface of the sheet member is an external electrode connected electrically to the probes through the wiring patterns, thereby enabling an electrical connection to a measuring instrument with ease.

In a case where a probe sheet related to Claim 3 of the present invention is adopted, circuit elements necessary for electrical measurement with the probes are disposed at positions close to the probes; therefore, enjoying a merit of improvement on a measurement precision.

In a case where a probe sheet related to Claim 4 of the present invention is adopted, a reinforcing member with an elasticity higher than a probe is provided integrally with the probe along the length direction, thereby enabling a strength of the probe to be enhanced.

In a case where a probe sheet related to Claim 5 of the present invention is adopted, a reinforcing member with an elasticity higher than a probe is provided in a clearance between a surface of the probe on the other side of the probe from the top of the probe and a sheet member; thereby enabling a strength of the probe to be enhanced.

In a case where a probe sheet related to Claim 6 of the present invention is adopted, the sheet member is made of a material of a linear expansion coefficient in the range of 2.5 to 10.5 ppm/°C. That is, the sheet member is made of a material with the same linear expansion coefficient as a measuring objective; therefore, the sheet member deforms in the same way as the measurement objective, by a change in temperature in a measurement environment, Therefore, probes formed on the sheet member can follow up positional shifts of corresponding electrodes accompanying deformation of the measurement objective.

In a case where a probe sheet unit related to Claim 7 of the present invention is adopted, an elastic member pushes a deformed sheet member so as to return to an original state thereof while absorbing elastic deformation of a sheet member, therefore enabling adaptation for a dispersion in height of electrodes and/or a dispersion in height of probes with more flexibility.

A description will now be given by way of example only, of a probe sheet unit related to an embodiment of the present invention with reference to the accompanying drawings, in which:

Fig. 1 is a schematic sectional view of a probe sheet unit related to the embodiment of the present invention;

Fig. 2 is a schematic sectional view showing part of a probe sheet having a sheet member made of one sheet of the unit;

Fig. 3 is a schematic sectional view showing part of a probe sheet having a sheet member formed by laminating plural sheets of the unit;

Fig. 4 is a model views for describing other probes used in the unit;

Fig. 5 is model views for describing a reinforcing member for a probe;

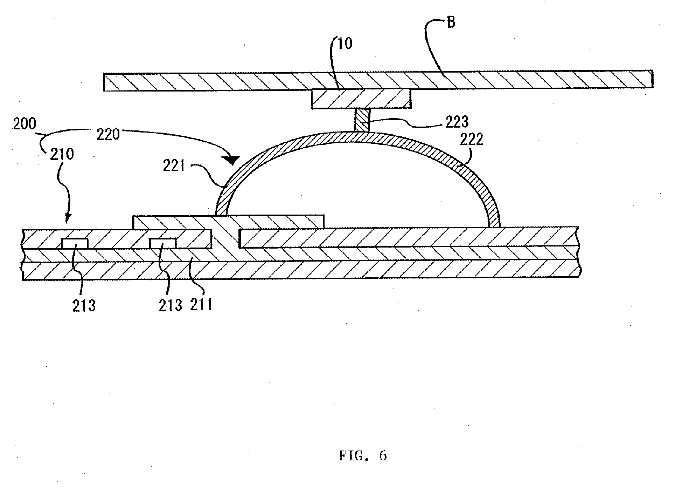

Fig. 6 is a schematic sectional view showing a state where a probe of the unit is in contact with an electrode of a measurement objective; and

Fig. 7 is a schematic sectional view of another probe sheet unit.

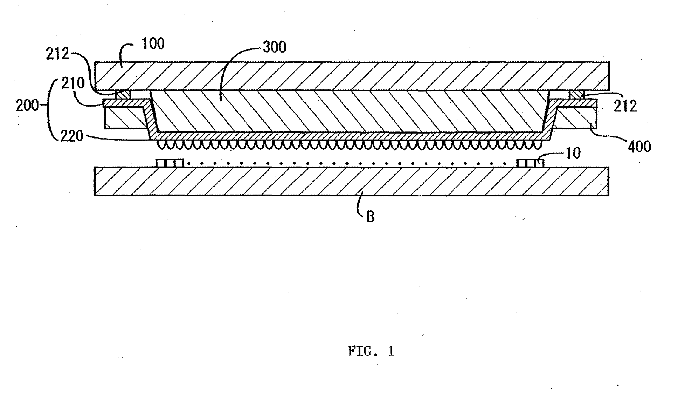

A probe sheet unit A shown in Fig. 1 is a sensing section of a measuring instrument (not shown) for a measurement objective B and includes: a base plate 100 mounted to a prober of the instrument; and a probe sheet 200 mounted to a lower surface of the base plate 100. Detailed description will be given of constituents of the instrument below.

The probe sheet 200 includes: a sheet member 210 having a flexibility; and plural probes 220 for measurement provided on one surface of the sheet member 210. The sheet member 210 has a flexibility and is made of a material with a linear expansion coefficient in the range of from 2.5 to 10.5 ppm/°C. Examples thereof include a single insulating sheet made of silicon, a single insulating sheet made of a plastic, a sheet formed by laminating plural insulating sheets made of silicon, a sheet formed by laminating plural insulating sheets made of a plastic, and the like.

That is, by using a material with the same linear expansion coefficient as or a linear expansion coefficient similar to that of the measurement objective B, the sheet member 210 can be expanded or shrunk in a similar way to that the measurement objective B is expanded or shrunk. With such a material employed, the probes 220 formed on a surface of the sheet member 210 can follow up positional shifts of corresponding electrodes accompanying expansion or shrinkage of the measurement objective B.

The reason why a linear expansion coefficient of the sheet member 210 is set in the range of from 2.5 to 10.5 ppm/°C is as follows: First of all, since almost all of measurement objectives B are of a size in the range of from $10 \times 10$ mm to $300 \times 300$ mm, if a material of the measurement objectives B is silicon, a linear expansion coefficient is 2.5 ppm/°C, and a relative positional shift between a measurement objective B and the sheet member 210 is confined to 10 μm or less under a condition that a measurement environment temperature is in the range of from ordinary temperature (25°C) to 150°C, a linear expansion coefficient of the sheet member 210 in a case where a size of a measurement objective B is $10 \times 10$ mm and a linear expansion coefficient of the sheet member 210 in a case where a size of a measurement objective B is $300 \times 300$ mm are obtained in ways described below:

In the case where a size of a measurement objective B is $10 \times 10$ mm,

[Formula 1]

$$10 \text{ mm} \times X \times (150°C - 25°C) = 10 \text{ μm}$$

$$X = 8 \text{ ppm/°C}$$

In the case where a size of a measurement objective B is $300 \times 300$ mm,

[Formula 2]

$$300 \text{ mm} \times X \times (150°C - 25°C) = 10 \text{ μm}$$

$$X = 0.27 \text{ ppm/}°C$$

In consideration of a fact that the measurement objective B also expands with heat at the same time that the sheet member 210 expands with heat, a linear expansion coefficient of 2.5 ppm/°C of the measurement objective B is added respectively to the linear expansion coefficient 8 ppm/°C in the case where a size of a measurement objective B is 10 × 10 mm and to the linear expansion coefficient 0.27 ppm/°C in the case where a size of a measurement objective B is 300 × 300 mm. Then, the former takes 10.5 ppm/°C and the latter takes 2.77 ppm/°C. That is, by using a material of a linear expansion coefficient in the range of from 2.77 to 10.5 ppm/°C as a material of the sheet member 210, a sheet member can be adapted for an expansion coefficient of almost all measurement objectives, while with consideration given to a technique that silicon same as the measurement objective B is used as a material of the sheet member 210, a linear expansion coefficient of the sheet member 210 is set in the range of from 2.5 to 10.5 ppm/°C.

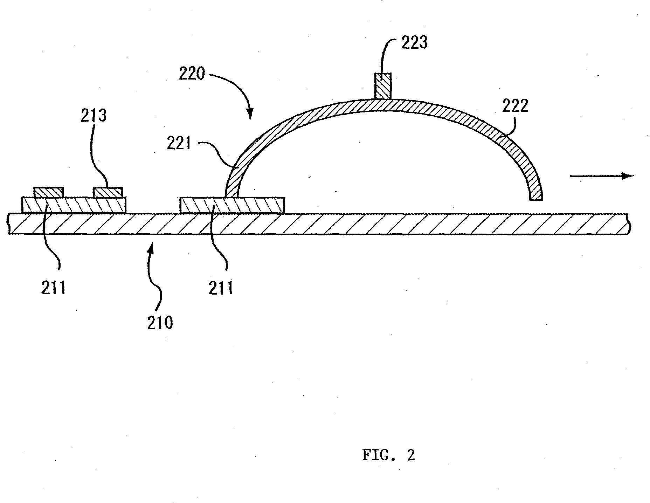

In a case where a sheet member 210 is made of one sheet, as shown in Figs. 1 and 2, wiring patterns 211 is provided on one surface thereof and an external electrode 212 is provided on the other surface thereof at the edge. The external electrode 212 and the probes 220 are connected electrically to each other through the wiring patterns 211.

Circuit elements 213 connected electrically to the wiring patterns 211 are provided on the one surface of the sheet member 210. A circuit element 213 is an element necessary to conduct electric measurement with a probe and, in this case, includes a capacitor functioning as a so-called pass capacitor and a circuit element functioning as a BOST (built out self test) circuit assisting a test (that is, measurement of an electric characteristic of a measurement objective B). The capacitor plays a role to improve high frequency characteristics. The circuit element functioning as a BOST circuit plays a role that alters according to contents of a test on a measurement objective B.

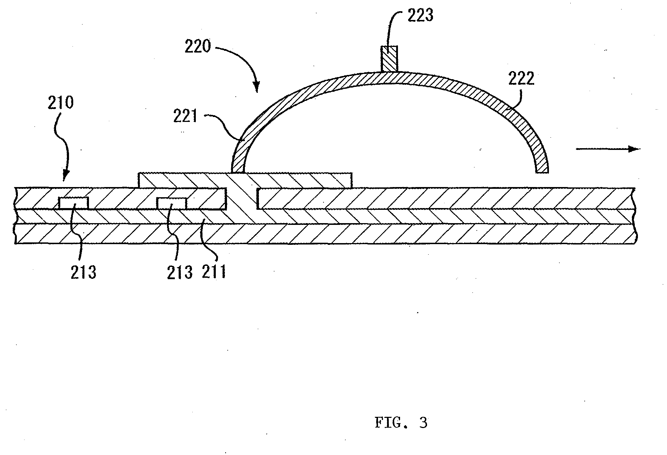

On the other hand, in a case where a sheet member 210 is formed by laminating plural sheets, as shown in Figs. 1 and 3, plural wiring patterns 211 are formed on one surfaces of respective sheets and an external electrode 212 is provided on the other surface of the sheet member 210 at the edge thereof. The wiring patterns 211 in each sheet and the lower sheet thereof are connected electrically to each other. The external electrode 212 and the probes 220 are connected electrically to each other through the wiring patterns 211. Circuit elements 213 described above are also provided on each sheet of the sheet member 210.

The probe 220 is formed on one surface of the sheet member 210 integrally with the one surface thereof in a procedure in which a resist is coated on the one surface of the sheet member 210 to form patterns on the resist and to plate the one surface thereof in conformity with the patterns, and such a process is repeated. Note that a pitch of the probes 220 is the same as that of electrodes 10 of a measurement objective B so that the probes 220 can be brought into contact with the corresponding electrodes 10 of the measurement object B and in this case, the pitch is set at 25 μm.

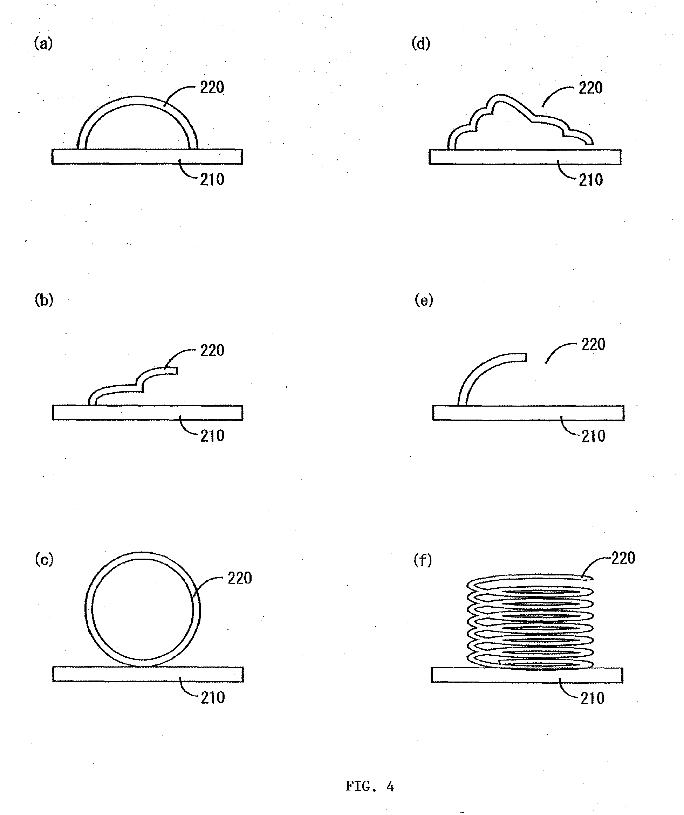

Each of the probes 220 has a shape capable of elastic deformation at least in a direction, upward or downward, for absorbing a dispersion in height of the electrodes 10 of the contactable measurement objective B. Examples of probes 220 include, as shown in Figs. 2 and 3, one formed on the one surface of the sheet member 210, in the shape of a half-circle arc and with one end thereof being supported by the sheet member 210; as shown in Fig. 4(a), one in the shape of a circle arc, and with both ends thereof connected the sheet member 210; as shown in Fig. 4(b), one, one end of which supported by the sheet member 210, and having plural curved portions in the length direction of the sheet member 210; as shown in Fig. 4(c), one in the shape of a circle, and with both ends thereof connected to the sheet member 210; as shown in Fig. 4(d), one, one of which is supported by the sheet member 210, and having plural curved portions; as shown in Fig. 4(e), one, one end of which is supported by the sheet member 210 and having one curved portion in the length direction of the sheet member 210; as shown in Fig. 4(f), one in the shape of a coil spring; and others. A contact terminal 223 as a projection, which is brought into contact with the electrode 10 of the measurement objective B, can be provided at the top of the probe 220 located at almost the center thereof. For convenience of explanation, with respect to the probe 220, description will be given of a probe which is in the shape of a half-circle arc and with one end thereof being supported as shown in Figs. 2 and 3, as an example.

A probe 220 has a shape including a first quarter circle arc portion 221 one end of which is supported by the sheet member 210 and a second quarter circle arc portion 222, which is connected to the other end of the first quarter circle arc portion 221 and a little shorter than the first quarter circle arc portion 221. A contact terminal 223 as a projection is provided at the top of the probe 220 located at almost the center thereof.

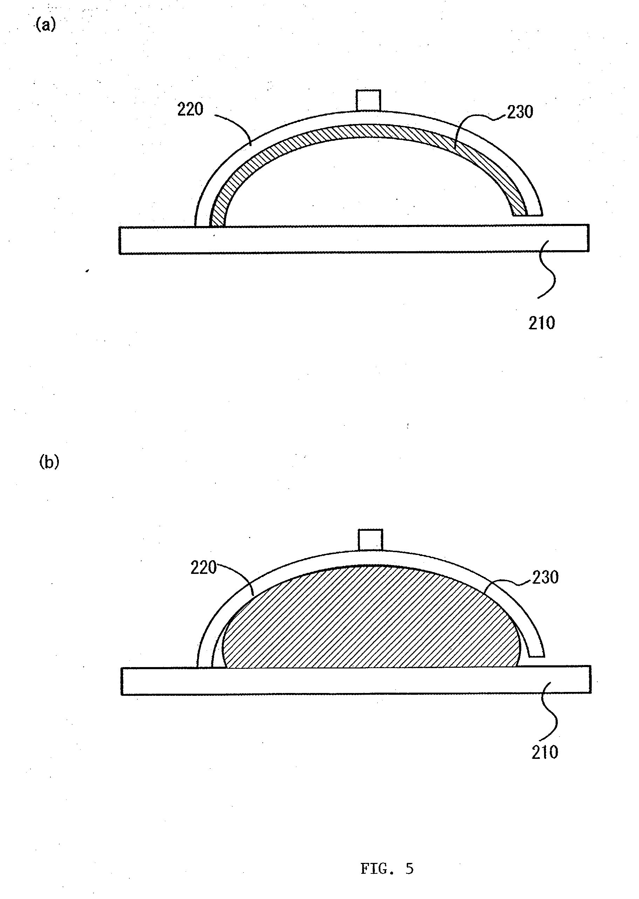

A probe 220 can also be of a structure in which as shown with oblique hatching in Fig. 5(a), a reinforcing member 230 made of alumina with an elasticity higher than the probe 220, in the fabrication process, is formed integrally with the probe 220, along the length direction, on the surface of the probe 220 opposite the sheet member 210. The reinforcing member 230 can also made as plural layers. In a case where a probe 220 brought into contact with an electrode 10 of the measurement objective B is, as shown with oblique hatching in Fig. 5(b), curved and has a clearance between a surface on the other side of the probe 220 from the top thereof and the sheet member 210, a reinforcing member 230 such as an elastomer with an elasticity higher than the probe 220 may be interposed in the clearance. The reinforcing member 230 as an elastomer is interposed in the clearance in a fabrication process of the probes 220.

Used as the base plate 100 is PCB on which a wiring pattern (not shown) is formed for electrical connection to the prober. The wiring pattern is connected to electrically to the external electrode 212 on the sheet member 210. The sheet member 210 is mounted to the base plate 100 by adhesion, compression bonding or the like so as to assume a shape of almost an inverse Greek Π with a flange at the top opening thereof. In the course of the mounting, an elastic member 300 is inserted between the base plate 100 and the sheet member 210.

Employed as the elastic member 300 are an elastic resin such as rubber, a bag filled with water or air, a spring, or the like. The elastic member 300 out of operation pushes a region of the sheet member 210 on which the probes 220 are formed so as to maintain the sheet member 210 in a flat state as shown in Fig. 1. When the probes 220 are brought into contact with the electrodes 10 on a semiconductor wafer B, the elastic member 300 absorbs elastic deformation of the sheet member 210 accompanying the contact.

A frame 400 is a member supporting the sheet member 210 and the elastic member 300 as shown in Fig. 1 and mounted to the base plate 100.

A probe sheet unit A with such a construction is mounted to the prober of a measuring instrument and used for measurement of electric characteristics of a measurement objective B. Detailed information will be given of a usage method thereof below. Note that a tester of the measuring instrument and the probe sheet unit A are connected electrically to each other through the external electrode 212.

First off, a driving apparatus for the prober is activated so as to cause the base plate 100 and the measurement objective B to move relatively close to each other. Such a movement brings the contact terminals 223 of the probes 200 and the corresponding electrodes 10 of the measurement objective B into contact with each other. Thereafter, the base plate 100 and the measurement objective B are moved close to each other to thereby press the contact terminals 223 against the corresponding electrodes 10 of the measurement objective B (that is, overdriven).

In this course, the probes 220, the sheet member 210 and the elastic member 300, or the sheet member 210 and the elastic member 300 are elastically deformed independently of one another so as to be adapted for a dispersion in height of the electrodes 10, having various heights, of the measurement objective B to thereby absorb the dispersion.

At this time, a probe 220 is elastically deformed in a direction, upward or downward, in parallel thereto, the distal end of the second quarter circle arc portion 222 is brought into contact with the one surface of the sheet member 210 and thereafter, the distal end thereof moves on the one surface of the sheet member 210 (in a direction of an arrow mark of Fig. 2). With such a movement of the probe 220, not only is a load due to overdriving imposed on the probe 220, which has become week because of miniaturization, dispersed, but it is also possible to secure a predetermined contact pressure required for electric conductance between the probe 220 and the corresponding electrode 10 and a scrubbing distance (that is, a distance over which the distal end of the second quarter circle arc portion 222 slides on a surface of the electrode 10).

Then, after measurement of the measurement objective B with a tester ends, the driving apparatus for the prober is activated to cause the base plate 100 and the measurement objective B to move relatively away from each other. During the course, the sheet member 210 are pushed by the elastic member 300 to restore the original position.

In a case where such a probe sheet unit A is employed, the probe sheet 220 and the sheet member 210 are elastically deformed independently of or together with each other, thereby enabling adaptation for a dispersion in height of the electrodes 10 of the measurement objective B and/or a dispersion in height of the probes 220. Therefore, since there is no chance that part of the probes is not brought into contact with the corresponding electrodes, which occurs in a conventional example., thereby enabling correct measurement.

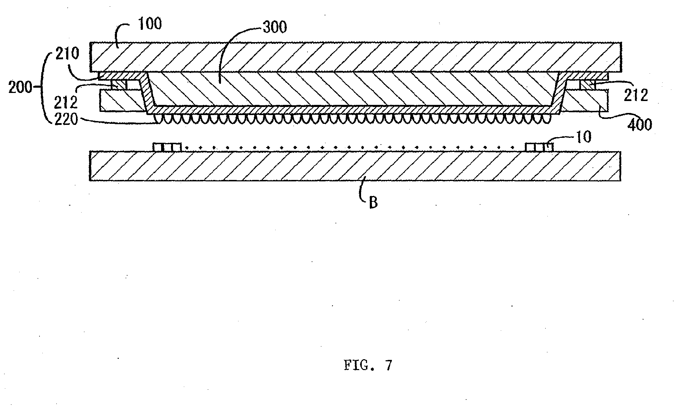

While PCB is employed as the base plate 100, any plate member can be employed without causing a problem as far as it has a stiffness capable of enduring elastic deformation of the elastic member 300. Therefore, in a case where the above plate is employed as the base plate 100 as shown in Fig. 7, PCB is employed as the frame 400. If a design is altered this way, the wiring patterns 211 and the external electrode 212 are not required to be formed on a surface of the sheet member 210 in contact with the base plate 100 and the elastic member 300; therefore, enabling electrical connection to the frame 400, which is PCB, with ease.

The elastic member 300 is not necessarily to be provided. That is, all of the other surface of the sheet member 210 can also be mounted so as to be adhered to the lower surface of the base plate 100. Even with a structure having no elastic member 300 in such a way, inclination and bending to a large or small extent of a measurement objective B can be adapted for by elastic deformation of the sheet member 210 and the probes 220.

Note that needless to say that the probe sheet 200 can be mounted directly to the prober without being mounted to the base plate 100.

**Claims**

1. A probe sheet comprising: a sheet member with a flexibility; and plural measurement probes provided on one surface of the sheet member, wherein each of the probes has a shape capable of elastic deformation in a direction, upward or downward.

2. A probe sheet according to claim 1, wherein wiring patterns are formed inside and/or on a surface of the sheet member and an external electrode connected electrically to the probes through the wiring patterns is provided on the surface of the sheet member.

3. A probe sheet according to claim 2, wherein circuit elements are provided inside and/or on a surface of the sheet member and the circuit elements are connected electrically to the wiring patterns.

4. A probe sheet according to claim 1, wherein each of the probes is curved and supported at one end thereof and a reinforcing member with an elasticity higher than a probe is provided integrally with the probe on a surface thereof facing the sheet member along the length direction.

5. A probe sheet according to claim 1, wherein each of the probes is curved and there is a predetermined clearance between a surface of a probe on the opposite side from the top of the probe at which the probe is brought into contact with an electrode of a measurement objective and the sheet member, and an reinforcement member with an elasticity higher than the probe is inserted in the clearance.

6. A probe sheet according to claim 1, wherein the sheet member is made of a material with a linear expansion coefficient in the range of from 2.5 to 10.5 ppm/°C.

7. A probe sheet unit which is a sensing section of a semiconductor wafer measuring instrument, comprising: a base plate mounted to a prober of the instrument; a probe sheet according to any of claims 1 to 6 mounted to a lower surface of the base plate; and an elastic member interposed between the base plate and the probe sheet.

FIG. 1

FIG. 2

FIG. 3

(a)

220

210

(d)

220

210

(b)

220

210

(e)

220

210

(c)

220

210

(f)

220

210

FIG. 4

(a)

220

230

210

(b)

220

230

210

FIG. 5

FIG. 6

FIG. 7

European Patent
Office

Application Number

EP 04 25 2736

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | WO 02/084313 A (ISMECA HOLDING SA; PERRET, JOEL) 24 October 2002 (2002-10-24)<br>* claim 1; figures 3,4 *<br>----- | 1-7 | G01R1/073 |
| X | "HIGH DENSITY PROBE ASSEMBLY"<br>RESEARCH DISCLOSURE, KENNETH MASON PUBLICATIONS, HAMPSHIRE, GB, no. 333, January 1992 (1992-01), page 82COMPL, XP000281295<br>ISSN: 0374-4353<br>* the whole document *<br>----- | 1 | |
| X | US 2003/048108 A1 (BEAMAN BRIAN SAMUEL ET AL) 13 March 2003 (2003-03-13)<br>* figures 3,4 *<br>----- | 1,2 | |
| X | US 5 723 347 A (HIRANO ET AL)<br>3 March 1998 (1998-03-03)<br>* figure 2 *<br>----- | 1 | |

TECHNICAL FIELDS
SEARCHED        (Int.Cl.7)

G01R

The present search report has been drawn up for all claims

| Place of search | Date of completion of the search | Examiner |
|---|---|---|
| The Hague | 23 February 2005 | Vytlacilová, L |

EPO FORM 1503 03.82 (P04C01)

**ANNEX TO THE EUROPEAN SEARCH REPORT
ON EUROPEAN PATENT APPLICATION NO.** EP 04 25 2736

This annex lists the patent family members relating to the patent documents cited in the above-mentioned European search report.
The members are as contained in the European Patent Office EDP file on
The European Patent Office is in no way liable for these particulars which are merely given for the purpose of information.

23-02-2005

| Patent document cited in search report | | Publication date | Patent family member(s) | | Publication date |
|---|---|---|---|---|---|
| WO 02084313 | A | 24-10-2002 | WO | 02084313 A1 | 24-10-2002 |
| US 2003048108 | A1 | 13-03-2003 | US | 6300780 B1 | 09-10-2001 |
| | | | US | 5821763 A | 13-10-1998 |
| | | | US | 5635846 A | 03-06-1997 |
| | | | US | 6062879 A | 16-05-2000 |
| | | | US | 2001045012 A1 | 29-11-2001 |
| | | | US | 6295729 B1 | 02-10-2001 |
| | | | US | 2002130676 A1 | 19-09-2002 |
| | | | US | 6452406 B1 | 17-09-2002 |
| | | | US | 2001054907 A1 | 27-12-2001 |
| | | | US | 6329827 B1 | 11-12-2001 |
| | | | US | 5914614 A | 22-06-1999 |
| | | | US | 5811982 A | 22-09-1998 |
| | | | US | 6286208 B1 | 11-09-2001 |
| | | | US | 5810607 A | 22-09-1998 |
| | | | US | 6054651 A | 25-04-2000 |
| | | | US | 6151701 A | 21-11-2000 |
| | | | US | 5838160 A | 17-11-1998 |
| | | | US | 6334247 B1 | 01-01-2002 |
| | | | US | 2003106213 A1 | 12-06-2003 |
| | | | US | 2004148773 A1 | 05-08-2004 |
| | | | JP | 3262531 B2 | 04-03-2002 |
| | | | JP | 11317476 A | 16-11-1999 |
| | | | US | 2002089344 A1 | 11-07-2002 |
| | | | US | 2002190738 A1 | 19-12-2002 |
| | | | US | 2004130343 A1 | 08-07-2004 |
| | | | US | 6104201 A | 15-08-2000 |
| | | | JP | 3578232 B2 | 20-10-2004 |
| | | | JP | 7287031 A | 31-10-1995 |
| | | | EP | 0925513 A1 | 30-06-1999 |
| | | | JP | 2000502811 T | 07-03-2000 |
| | | | JP | 3206922 B2 | 10-09-2001 |
| | | | WO | 9811449 A1 | 19-03-1998 |
| | | | EP | 0925510 A1 | 30-06-1999 |
| | | | JP | 2000502812 T | 07-03-2000 |
| | | | WO | 9811446 A1 | 19-03-1998 |
| | | | EP | 0925509 A1 | 30-06-1999 |
| | | | JP | 2000502810 T | 07-03-2000 |
| | | | WO | 9811445 A1 | 19-03-1998 |
| US 5723347 | A | 03-03-1998 | JP | 2710544 B2 | 10-02-1998 |
| | | | JP | 7113842 A | 02-05-1995 |
| | | | US | 5625298 A | 29-04-1997 |
| | | | EP | 0646800 A1 | 05-04-1995 |

EPO FORM P0459

For more details about this annex : see Official Journal of the European Patent Office, No. 12/82